# EUROPEAN PATENT APPLICATION

(11) **EP 4 435 839 A1**
(43) Date of publication of application: **25.09.2024**
(21) Application number: 24161262.1
(22) Date of filing: 04.03.2024
(51) Int. Cl.: H01L 21/67, H01J 37/32

(54) **SUBSTRATE PROCESSING APPARATUS, CLEANING METHOD, SUBSTRATE PROCESSING METHOD, METHOD OF MANUFACTURING SEMICONDUCTOR DEVICE AND PROGRAM**

(30) Priority: 24.03.2023 JP 2023048223
(71) Applicant: Kokusai Electric Corp., Tokyo 1010045 (JP)
(72) Inventor: YAMAMOTO, Kaoru, Toyama-shi, 939-2393 (JP)
(74) Representative: Verscht, Thomas Kurt Albert

(57) **Abstract**

There is provided a technique capable of effectively performing a cleaning process. There is provided a technique that includes: a process chamber; a process gas supplier; a cleaning gas supplier; a substrate support including a substrate placing surface for supporting a product substrate or a dummy substrate whose diameter is smaller than that of the product substrate; and a controller capable of control operations for processing the product substrate by supplying the process gas; and performing a cleaning process on a cleaning target formed by the process gas entering between a back surface of the product substrate and the substrate placing surface, wherein the cleaning process is performed by supplying the cleaning gas to at least a portion of the substrate placing surface corresponding to an outer circumference of the dummy substrate in a state where the dummy substrate is supported on the substrate placing surface.

## Description

### [Technical Field]

The present disclosure relates to a substrate processing apparatus, a cleaning method, a substrate processing method, a method of manufacturing a semiconductor device and a program.

### [Related Art]

In a substrate processing apparatus used in a manufacturing process of a semiconductor device, a cleaning process of removing a substance such as a by-product by supplying a cleaning gas into a process chamber in which a substrate is processed may be performed (For example, see Patent Document 1).

### [Related Art Document]

### [Patent document]

[Patent Document 1] Japanese Patent Application Laid-Open No. 2021-111760

### [Disclosure]

### [Technical Problem]

According to the present disclosure, there is provided a technique capable of effectively performing a cleaning process.

### [Technical Solution]

According to an aspect of the present disclosure, there is provided a technique that includes: (a) a process chamber; (b) a process gas supplier configured to supply a process gas into the process chamber; (c) a cleaning gas supplier configured to supply a cleaning gas into the process chamber; (d) a substrate support provided with a substrate placing surface on which a product substrate or a dummy substrate whose diameter is smaller than that of the product substrate is capable of being supported; and (e) a controller configured to be capable of controlling the process gas supplier and the cleaning gas supplier to perform: processing the product substrate by supplying the process gas in a state where the product substrate is supported on the substrate placing surface; and performing a cleaning process on a cleaning target formed by the process gas that has entered between a back surface of the product substrate and the substrate placing surface when the product substrate is processed, wherein the cleaning process is performed by supplying the cleaning gas to at least a portion of the substrate placing surface corresponding to an outer circumference of the dummy substrate in a state where the dummy substrate is supported on the substrate placing surface.

### [Advantageous Effects]

According to some embodiments of the present disclosure, it is possible to effectively perform the cleaning process.

### [Brief Description of Drawings]

FIG. 1 is a diagram schematically illustrating a horizontal cross-section of a substrate processing apparatus according to one or more embodiments of the present disclosure.
FIG. 2 is a diagram schematically illustrating a vertical cross-section of the substrate processing apparatus according to the embodiments of the present disclosure.
FIG. 3 is a diagram schematically illustrating a configuration of a process vessel (chamber) of the substrate processing apparatus according to the embodiments of the present disclosure.
FIG. 4 is a diagram schematically illustrating an example of a substrate mounting state in the substrate processing apparatus according to the embodiments of the present disclosure.
FIG. 5 is a diagram schematically illustrating another example of the substrate mounting state in the substrate processing apparatus according to the embodiments of the present disclosure.
FIG. 6 is a diagram schematically illustrating a configuration of a gas supplier of the substrate processing apparatus according to the embodiments of the present disclosure.
FIG. 7 is a block diagram schematically illustrating a functional configuration of a controller of the substrate processing apparatus according to the embodiments of the present disclosure.
FIG. 8 is a flow diagram schematically illustrating a substrate processing according to the embodiments of the present disclosure.
FIG. 9 is a flow diagram schematically illustrating a cleaning process according to the embodiments of the present disclosure.

### [Detailed Description]

### <Embodiments of Present Disclosure>

Hereinafter, one or more embodiments (also simply referred to as "embodiments") according to the technique of the present disclosure will be described with reference to the drawings. The drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match.

### (1) Configuration of Substrate Processing Apparatus

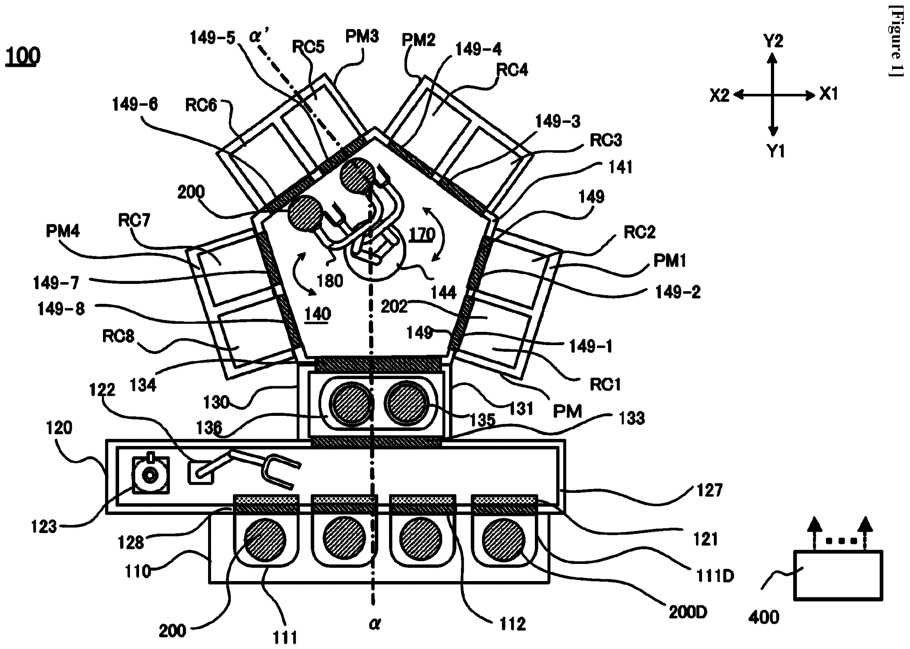

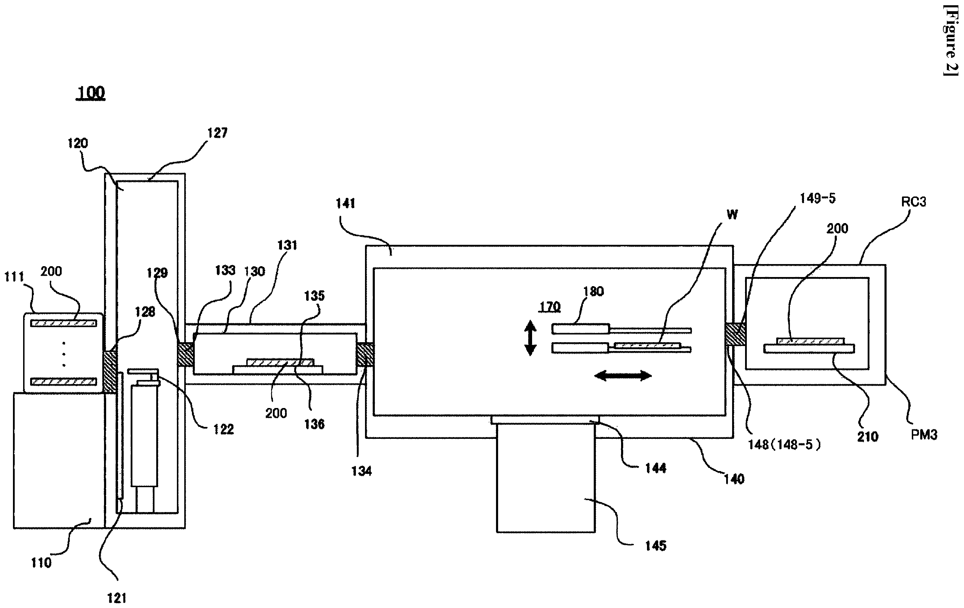

Hereinafter, a substrate processing apparatus 100 according to the present embodiments will be described with reference to FIGS. 1 and 2. FIG. 1 is a diagram schematically illustrating a horizontal cross-section of an exemplary configuration of the substrate processing apparatus 100 according to the present embodiments. FIG. 2 is a diagram schematically illustrating a vertical cross-section of the exemplary configuration of the substrate processing apparatus 100 according to the present embodiments, taken along a line α - α' shown in FIG. 1.

### <Overall Configuration>

As shown in FIGS. 1 and 2, the substrate processing apparatus 100 to which the present embodiments are applied is configured to process a substrate 200. The substrate processing apparatus 100 is constituted mainly by an I/O stage (input/output stage) 110, an atmospheric transfer chamber 120, a load lock chamber 130, a vacuum transfer chamber 140, and a process module PM. Hereinafter, components of the substrate processing apparatus 100 will be described in detail. In the description of FIG. 1, front, rear, left and right directions are indicated by arrows Y₁, Y₂, X₂ and arrow X₁, respectively.

The I/O stage (also referred to as a "loading port shelf") 110 is provided at a front of the substrate processing apparatus 100. A plurality of pods 111 can be placed on the I/O stage 110. In the present specification, a pod among the plurality of pods 111 may also be simply referred to as a "pod 111". The pod 111 is used as a carrier for transferring the substrate 200 such as a silicon (Si) substrate. The substrate 200 may also be referred to as a "product substrate" or a "product wafer". In addition to the pod 111, the I/O stage 110 is provided with a dummy substrate stocker 112 serving as a dummy substrate storage where a dummy substrate 200D is stored. The dummy substrate 200D may also be referred to as a "dummy wafer". The product substrate 200 and the dummy substrate 200D will be described later in detail.

The I/O stage 110 is provided adjacent to the atmospheric transfer chamber 120. The load lock chamber 130 described later is connected to a side surface of the atmospheric transfer chamber 120 other than a side surface at which the I/O stage 110 is provided. An atmospheric transfer robot 122 configured to transfer the product substrate 200 or the dummy substrate 200D is provided in the atmospheric transfer chamber 120. In addition, an aligner (which is an alignment structure) (hereinafter, also referred to as a "pre-aligner") 123 configured to align an orientation flat or a notch formed on the product substrate 200 or the dummy substrate 200D is located in the atmospheric transfer chamber 120 at a position other than where the atmospheric transfer robot 122 is provided.

A substrate loading/unloading port 128 through which the product substrate 200 or the dummy substrate 200D is transferred (loaded or unloaded) into or out of the atmospheric transfer chamber 120 and a pod opener 121 are provided at a front side of a housing 127 of the atmospheric transfer chamber 120. A substrate loading/unloading port 129 through which the product substrate 200 or the dummy substrate 200D is transferred (loaded or unloaded) into or out of the load lock chamber 130 is provided at a rear side of the housing 127 of the atmospheric transfer chamber 120. The substrate loading/unloading port 129 is opened or closed by a gate valve 133. When the substrate loading/unloading port 129 is opened by the gate valve 133, the product substrate 200 or the dummy substrate 200D may be transferred (or loaded) into or transferred (or unloaded) out of the load lock chamber 130.

The load lock chamber 130 is provided adjacent to the atmospheric transfer chamber 120. The vacuum transfer chamber 140 described later is provided at a side surface of a housing 131 constituting the load lock chamber 130 other than a side surface of the housing 131 that is adjacent to the atmospheric transfer chamber 120. The vacuum transfer chamber 140 is connected to the load lock chamber 130 via a gate valve 134.

A substrate mounting table 136 provided with at least two placing surfaces 135 on which the product substrate 200 or the dummy substrate 200D is placed is provided in the load lock chamber 130. A distance between the two placing surfaces 135 may be set based on a distance between end effectors of an arm of a vacuum transfer robot 170 described later.

The substrate processing apparatus 100 includes the vacuum transfer chamber 140 serving as a transfer chamber (transfer space) in which the product substrate 200 is transferred under a negative pressure. For example, a housing 141 constituting the vacuum transfer chamber 140 is pentagonal when viewed from above. The load lock chamber 130 and the process module PM (that is, process modules PM1, PM2, PM3 and PM4) where the product substrate 200 is processed are connected to respective sides of the housing 141 of a pentagonal shape. In the present specification, the process modules PM1, PM2, PM3 and PM4 may be collectively or individually referred to as the "process module PM".

The vacuum transfer robot 170 capable of transferring the product substrate 200 or the dummy substrate 200D under the negative pressure is provided approximately at a center of the vacuum transfer chamber 140 with a flange 144 as a base. The vacuum transfer robot 170 serves as a transfer structure.

The vacuum transfer robot 170 provided in the vacuum transfer chamber 140 is configured to be elevated or lowered by an elevator 145 while maintaining the vacuum transfer chamber 140 airtight by the flange 144. The vacuum transfer robot 170 is provided with two arms 180. Hereinafter, the two arms 180 may be also be collectively or individually referred to as an "arm 180". The arm 180 is provided with the end effectors on which the product wafer 200 is placed. In FIG. 2, for convenience of explanation, the end effectors of the arm 180 are illustrated, and a configuration such as a robot shaft connected to the flange 144 is omitted.

The two arms 180 of the vacuum transfer robot 170 is configured to be elevated and lowered by the elevator 145. The elevator 145 is configured to elevate and lower the arm 180 and to rotate the arm 180. The arm 180 is capable of being rotated and extended around an arm axis. By rotating or extending the arm 180, it is possible to load the product substrate 200 or the dummy substrate 200D into the process module PM and to unload the product substrate 200 or the dummy substrate 200D from the process module PM.

The process modules PM1 to PM4 are respectively arranged radially around the vacuum transfer chamber 140 on side walls of the housing 141 (which is pentagonal when viewed from above) constituting the vacuum transfer chamber 140 other than a side wall of the housing 141 where the load lock chamber 130 is provided.

Each of the process modules PM1 to PM4 is provided with a chamber RC serving as a process vessel in which the product substrate 200 is processed. Specifically, the process module PM1 is provided with chambers RC1 and RC2. The process module PM2 is provided with chambers RC3 and RC4. The process module PM3 is provided with chambers RC5 and RC6. The process module PM4 is provided with chambers RC7 and RC8. That is, each process module PM is provided with a plurality of chambers (for example, two chambers) RC. Hereinafter, the plurality of chambers RC may be also be collectively or individually referred to as the "chamber RC".

A substrate loading/unloading port 148 is provided in each of the sidewalls of the housing 141 facing the process modules PM1 to PM4. The substrate loading/unloading port 148 is provided individually corresponding to each chamber RC in the process modules PM1 to PM4. Further, a gate valve 149 is provided at each substrate loading/unloading port 148. Specifically, gate valves 149-1 and 149-2 are provided corresponding to the chambers RC1 and RC2 in the process module PM1. Gate valves 149-3 and 149-4 are provided corresponding to the chambers RC3 and RC4 in the process module PM2. Gate valves 149-5 and 149-6 are provided corresponding to the chambers RC5 and RC6 in the process module PM3. Gate valves 149-7 and 149-8 are provided corresponding to the chambers RC7 and RC8 in the process module PM4.

By opening and closing each gate valve 149, it is possible to transfer the product substrate 200 or the dummy substrate 200D into or out of the chamber RC through the substrate loading/unloading port 148.

### <Configuration of Chamber (Process Vessel)>

Subsequently, a configuration of the chamber RC (that is, the chambers RC1 to RC8) will be described. Since configurations of the chambers RC1 to RC8 are substantially the same, in the following descriptions, the chamber RC will be described in detail below.

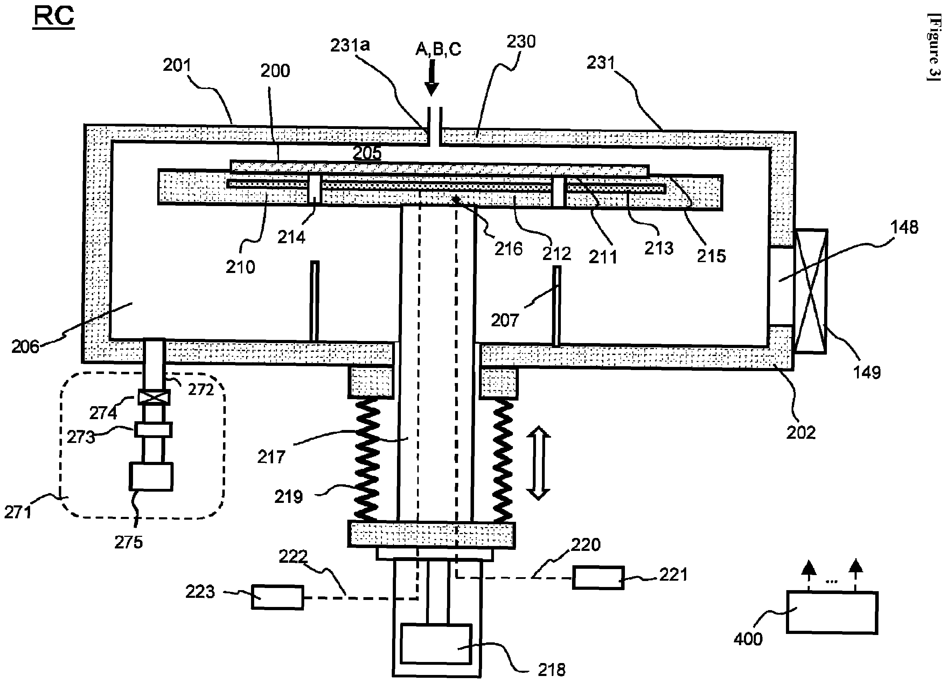

Hereinafter, the present embodiments will be described by way of an example in which the chamber RC functions as a single wafer type substrate processing apparatus configured to process the product substrate 200 to be processed one by one. FIG. 3 is a diagram schematically illustrating a configuration of the process vessel (chamber) of the substrate processing apparatus 100 according to the embodiments of the present disclosure.

The chamber RC includes a vessel 202 serving as the process vessel in which the product substrate 200 is processed. For example, the vessel 202 is configured as a flat and sealed vessel with a circular horizontal cross-section. For example, the vessel 202 is made of a metal material such as aluminum (Al) and stainless steel (SUS). A process chamber 201 constituting a process space 205 for processing at least the product substrate 200 such as the silicon wafer is provided in the vessel 202. That is, the chamber RC is configured to include at least the process space 205 in which the substrate 200 can be processed.

The substrate loading/unloading port (also referred to as a "communication hole") 148 is provided adjacent to the gate valve 149 at a side surface of the vessel 202, and the product substrate 200 or the dummy substrate 200D is transferred into or out of the vacuum transfer chamber 140 through the communication hole 148. A plurality of lift pins 207 are provided at a bottom of the vessel 202.

A substrate support 210 serving as a support structure configured to support the product substrate 200 or the dummy substrate 200D is provided in the process space 205. The substrate support 210 mainly includes: a substrate mounting table 212 provided with a substrate placing surface 211 on which the product substrate 200 or the dummy substrate 200D is placed; and a heater 213 serving as a heating structure embedded in the substrate mounting table 212. A plurality of through-holes 214 through which the lift pins 207 penetrate are provided at positions on the substrate mounting table 212 corresponding to the lift pins 207.

Wiring 222 configured to supply an electric power to the heater 213 is connected to the heater 213. The wiring 222 is connected to a heater controller 223. The heater controller 223 is electrically connected to a controller 400. The controller 400 is configured to control the heater controller 223 to operate the heater 213. For example, the heater 213 may be controlled based on a detection result by a temperature controller 221 connected to a temperature sensor 216 provided in the substrate mounting table 212 via wiring 220.

The substrate mounting table 212 is supported by a shaft 217. The shaft 217 penetrates the bottom of the vessel 202, and is connected to an elevator 218 at an outside of the vessel 202. By operating the elevator 218 to elevate or lower the shaft 217 and the substrate mounting table 212, the product substrate 200 or the dummy substrate 200D placed on the substrate placing surface 211 of the substrate mounting table 212 is capable of being elevated or lowered. Further, a bellows 219 covers a periphery of a lower end of the shaft 217 to maintain the chamber RC airtight.

When the product substrate 200 or the dummy substrate 200D is transferred, the substrate mounting table 212 is lowered until the substrate placing surface 211 reaches a position (also referred to as a "substrate transfer position") at which the substrate placing surface 211 faces the communication hole 148. When the product substrate 200 or the dummy substrate 200D is processed, the substrate mounting table 212 is elevated until the product substrate 200 or the dummy substrate 200D reaches a processing position (also referred to as a "substrate processing position") in the process chamber 201.

A buffer structure 230 configured to diffuse a gas is provided above (that is, at an upstream side of) the process space 205. The buffer structure 230 is constituted mainly by a lid 231. At least a first gas supplier (which is a first gas supply structure or a first gas supply system) 241, a second gas supplier (which is a second gas supply structure or a second gas supply system) 242, and a third gas supplier (which is a third gas supply structure or a third gas supply system) 243, which will be described later, are connected to the lid 231 so as to communicate with a gas introduction hole 231a provided in the lid 231. Instead of the gas introduction hole 231a common to the first gas supplier 241, the second gas supplier 242 and the third gas supplier 243 shown in FIG. 3, a plurality of gas introduction holes may be provided for the first gas supplier 241, the second gas supplier 242 and the third gas supplier 243, respectively.

An exhauster (which is an exhaust structure or an exhaust system) 271 is connected to the process space 205. Specifically, an exhaust pipe 272 communicating with the process space 205 is connected to the vessel 202. An APC 273 serving as a pressure controller configured to control an inner pressure of the process space 205 to a predetermined pressure is provided at the exhaust pipe 272. The APC 273 is provided with a valve body (not shown) whose opening degree is capable of being adjusted. The APC 273 is configured to adjust a conductance of the exhaust pipe 272 in accordance with an instruction from the controller 400. Further, a valve 274 is provided on an upstream side of the APC 273 in the exhaust pipe 272. The exhaust pipe 272, the valve 274 and the APC 273 may be collectively referred to as the "exhauster 271".

Further, a dry pump (DP) 275 is provided downstream of the exhaust pipe 272. The DP 275 is configured to exhaust an inner atmosphere of the process space 205 through the exhaust pipe 272.

### <Product Substrate and Dummy Substrate>

Subsequently, the product substrate 200 and the dummy substrate 200D placed on the substrate placing surface 211 of the substrate support 210 will be described.

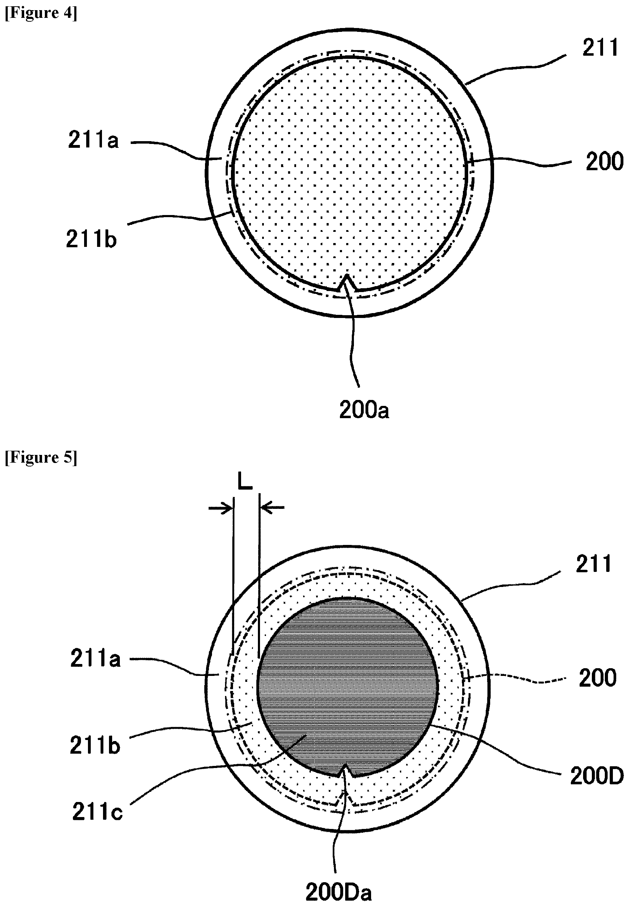

FIG. 4 is a diagram schematically illustrating an example of a substrate mounting state in the substrate processing apparatus 100 according to the embodiments of the present disclosure. In the example shown in FIG. 4, a state in which the product substrate 200 is placed on the substrate placing surface 211 is shown.

The product substrate 200 serves as an object to be processed in the process chamber 201. Therefore, the product substrate 200 is placed on the substrate placing surface 211 (whose outer shape is of a circular shape) of the substrate support 210 in a state where a notch 200a of the product substrate 200 is aligned in a predetermined direction. An outer circumference of the outer shape (circular shape) of the substrate placing surface 211 is set to be greater than an outer shape of the product substrate 200. Therefore, the product substrate 200 is placed on the substrate placing surface 211 in a state where an outer peripheral end of the product substrate 200 is supported by the substrate placing surface 211. In addition, while the present embodiments will be described by way of an example in which the notch 200a is provided in the product substrate 200, the orientation flat may be provided. The same may also be applied to a notch 200Da of the dummy substrate 200D, which will be described later.

The outer circumference of the substrate placing surface 211 is greater than the outer shape of the product substrate 200. Thereby, on the substrate placing surface 211, at least a first surface 211a whose outer edge is defined by the outer circumference of the substrate placing surface 211, and a second surface 211b which is an area located inside the first surface 211a and which serves as a mounting area of the product substrate 200 may exist. The second surface 211b is configured such that the outer peripheral end of the product substrate 200 is capable of being supported by the second surface 211b. More specifically, the product substrate 200 is supported by the second surface 211b such that an outer peripheral end (hereinafter, also referred to as an "edge") of a surface of the product substrate 200 (that is, a back surface of the product substrate 200 when a surface to be processed is a front surface of the product substrate 200) is in contact with the second surface 211b. Therefore, a boundary between the first surface 211a and the second surface 211b is arranged to be at least the same size as the outer shape of the product substrate 200 or greater than the outer shape of the product substrate 200.

It is also possible to place the dummy substrate 200D on the substrate placing surface 211 of the substrate support 210 instead of the product substrate 200.

FIG. 5 is a diagram schematically illustrating another example of the substrate mounting state in the substrate processing apparatus 100 according to the embodiments of the present disclosure. In the example shown in FIG. 5, a state in which the dummy substrate 200D is placed on the substrate placing surface 211 is shown.

The dummy substrate 200D is mainly used when a cleaning processing described later is performed. The dummy substrate 200D is of substantially the same shape as the product substrate 200. However, an outer shape of the dummy substrate 200D is set to be smaller than that of the product substrate 200. In other words, "substantially the same shape" described herein means that the outer shape of the dummy substrate 200D is substantially the same as that of the product substrate 200 (and the notch 200Da is provided in the dummy substrate 200D in the same manner as the notch 200a is provided in the product substrate 200) but a size of the dummy substrate 200D is different from that of the product substrate 200.

The dummy substrate 200D is of substantially the same shape as the product substrate 200. Thus, when supporting the dummy substrate 200D on the substrate placing surface 211, the dummy substrate 200D is placed thereon such that a position of the notch 200Da of the dummy substrate 200D is aligned with the position of the notch 200a in a case where the product substrate 200 is supported thereon (that is, the dummy substrate 200D is placed in a manner that the notch 200Da is aligned in the predetermined direction). Further, an outer shape of the dummy substrate 200D is set to be smaller than the outer shape of the product substrate 200. Therefore, the dummy substrate 200D is placed on the substrate placing surface 211 such that an outer circumference of the dummy substrate 200D is concentric with the outer circumference of the product substrate 200. As a result, when placed on the substrate placing surface 211, the outer circumference of the dummy substrate 200D is set such that a distance L between the outer circumference of the dummy substrate 200D and the outer circumference of the product substrate 200 is a constant distance.

Since the outer shape of the dummy substrate 200D is set to be smaller than the outer shape of the product substrate 200, in addition to the first surface 211a and the second surface 211b, a third surface 211c which is an area located inside the second surface 211b and whose outer edge is defined by the outer circumference of the dummy substrate 200D (that is, a mounting area of the dummy substrate 200D) may exist on the substrate placing surface 211. That is, the substrate placing surface 211 may include the first surface 211a, the second surface 211b and the third surface 211c.

To summarize the above, the outer edge of the first surface 211a of the substrate placing surface 211 is defined by the outer circumference of the substrate placing surface 211, and a diameter of the outer edge of the first surface 211a (that is, the outer circumference of the substrate placing surface 211) is set to be greater than a diameter of the outer circumference of the product substrate 200. Further, a diameter of an inner circumference of the first surface 211a is set to be the same as the diameter of the outer circumference of the product substrate 200 or set to be greater than the diameter of the outer circumference of the product substrate 200 (but set to be smaller than the outer circumference of the substrate placing surface 211). The second surface 211b of the substrate placing surface 211 is set such that a diameter of an outer circumference thereof matches the diameter of the inner circumference of the first surface 211a. Further, a diameter of an inner circumference of the second surface 211b is set to be the same as the diameter of the outer circumference of the dummy substrate 200D, and is set to be smaller than the diameter of the outer circumference of the product substrate 200. The third surface 211c of the substrate placing surface 211 is set such that a diameter of an outer circumference thereof matches the diameter of the inner circumference of the second surface 211b. The entire area inside the second surface 211b serves as the third surface 211c. That is, on the substrate placing surface 211, the first surface 211a, the second surface 211b and the third surface 211c are arranged concentrically in this order from an outer circumferential side to an inner circumferential side.

Among the first surface 211a, the second surface 211b and the third surface 211c of the substrate placing surface 211, at least the second surface 211b is provided with a cleaning gas resistant structure capable of suppressing an influence of the cleaning gas, which will be described later. The "influence of the cleaning gas" refers to an influence caused by an etching by the cleaning gas. Therefore, the cleaning gas resistant structure is capable of suppressing the etching by the cleaning gas. The cleaning gas resistant structure may be provided on the first surface 211a in addition to the second surface 211b. When the cleaning gas resistant structure is provided on both the first surface 211a and the second surface 211b, the cleaning gas resistant structure forms a ring structure in an annular shape since the first surface 211a, the second surface 211b and the third surface 211c are concentric.

### <Configuration of Gas Supplier>

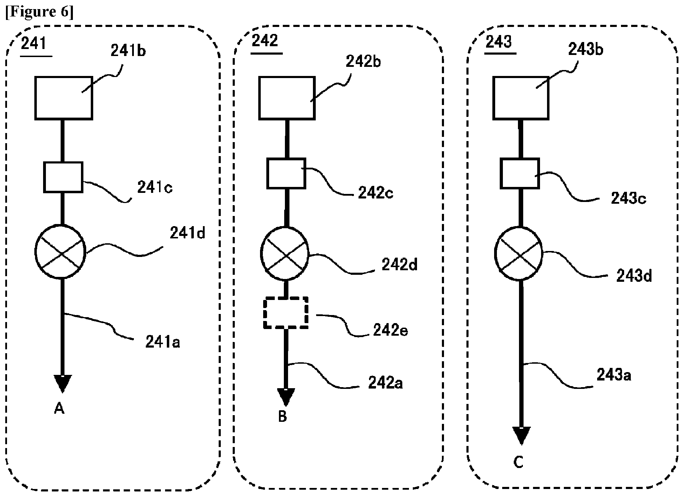

Subsequently, a gas supplier (which is a gas supply structure or a gas supply system) through which the gas is supplied into the process chamber 201 will be described with reference to FIG. 6. FIG. 6 is a diagram schematically illustrating a configuration of the gas supplier of the substrate processing apparatus 100 according to the embodiments of the present disclosure.

The gas supplier configured to supply the gas into the process chamber 201 may include at least the first gas supplier 241, the second gas supplier 242 and the third gas supplier 243.

The first gas supplier 241 includes a first gas supply pipe 241a communicating with the gas introduction hole 231a provided in the lid 231. A first gas source 241b, an MFC 241c serving as a flow rate controller (or a flow rate control structure) and a valve 241d serving as an opening/closing valve are sequentially provided in this order at the first gas supply pipe 241a from an upstream side toward a downstream side of the first gas supply pipe 241a in a gas flow direction.

The first gas source 241b is a source of a first gas (also referred to as a "first element-containing gas") containing a first element. The first element-containing gas serves as a source gas, which is one of process gases. According to the present embodiments, for example, the first element is silicon (Si). That is, for example, the first gas is a silicon-containing gas. More specifically, for example, hexachlorodisilane gas (Si₂Cl₆, abbreviated as HCDS) gas is used as the silicon-containing gas.

That is, the first gas supplier 241 is configured to function as a part of a process gas supplier (which is a process gas supply structure or a process gas supply system) configured to supply the process gases into the process chamber 201. The first gas supplier 241 is constituted mainly by the first gas supply pipe 241a, the MFC 241c and the valve 241d. The first gas supplier 241 may further include the first gas source 241b.

The second gas supplier 242 includes a second gas supply pipe 242a communicating with the gas introduction hole 231a provided in the lid 231. A second gas source 242b, an MFC 242c serving as a flow rate controller (or a flow rate control structure) and a valve 242d serving as an opening/closing valve are sequentially provided in this order at the second gas supply pipe 242a from an upstream side toward a downstream side of the second gas supply pipe 242a in the gas flow direction.

The second gas source 242b is a source of a second gas (also referred to as a "second element-containing gas") containing a second element. The second element-containing gas serves as one of the process gases. Further, the second gas may serve as a reactive gas or a modification gas. Hereinafter, the process gases may be collectively or individually referred to as a "process gas".

According to the present embodiments, for example, the second gas contains the second element different from the first element. As the second element, for example, one of oxygen (O), nitrogen (N) and carbon (C) may be used. According to the present embodiments, for example, a nitrogen-containing gas is used as the second element-containing gas. More specifically, ammonia (NH₃) gas is used as the nitrogen-containing gas.

A remote plasma unit (RPU) (which is a plasma generator) 242e may be provided at the second gas supply pipe 242. The RPU 242e is configured to convert the second gas passing through the second gas supply pipe 242a into a plasma state.

That is, the second gas supplier 242 is configured to function as a part of the process gas supplier configured to supply the process gases into the process chamber 201. The second gas supplier 242 is constituted mainly by the second gas supply pipe 242a, the MFC 242c and the valve 242d. The second gas supplier 242 may further include the second gas source 242b. For example, the second gas supplier 242 may further include the RPU 242e.

For example, when forming a film on the product substrate 200 using the first gas alone, the second gas supplier 242 may not be provided.

The third gas supplier 243 includes a third gas supply pipe 243a communicating with the gas introduction hole 231a provided in the lid 231. A third gas source 243b, an MFC 243c serving as a flow rate controller (or a flow rate control structure) and a valve 243d serving as an opening/closing valve are sequentially provided in this order at the third gas supply pipe 243a from an upstream side toward a downstream side of the third gas supply pipe 243a in the gas flow direction.

The third gas source 243b is a source of a cleaning gas for removing a substance such as a by-product attached to the chamber RC and the buffer structure 230 such as a shower head. The cleaning gas is one of non-process gases. For example, as the cleaning gas, a fluorine-containing gas containing fluorine (F) is used. For example, nitrogen trifluoride (NF₃) gas may be used as the fluorine-containing gas. Further, for example, as the fluorine-containing gas, a gas such as hydrogen fluoride (HF) gas, chlorine trifluoride gas (ClF₃) gas and fluorine (F₂) gas may be used, or a combination thereof may be used.

That is, the third gas supplier 243 is configured to function as a cleaning gas supplier (which is a cleaning gas supply structure or a cleaning gas supply system) configured to supply the cleaning gas into the process chamber 201. The third gas supplier 243 is constituted mainly by the third gas supply pipe 243a, the MFC 243c and the valve 243d. The third gas supplier 243 may further include the third gas source 243b.

### <Configuration of Controller>

The substrate processing apparatus 100 includes the controller 400 serving as a control structure (control apparatus) configured to control operations of components of the substrate processing apparatus 100.

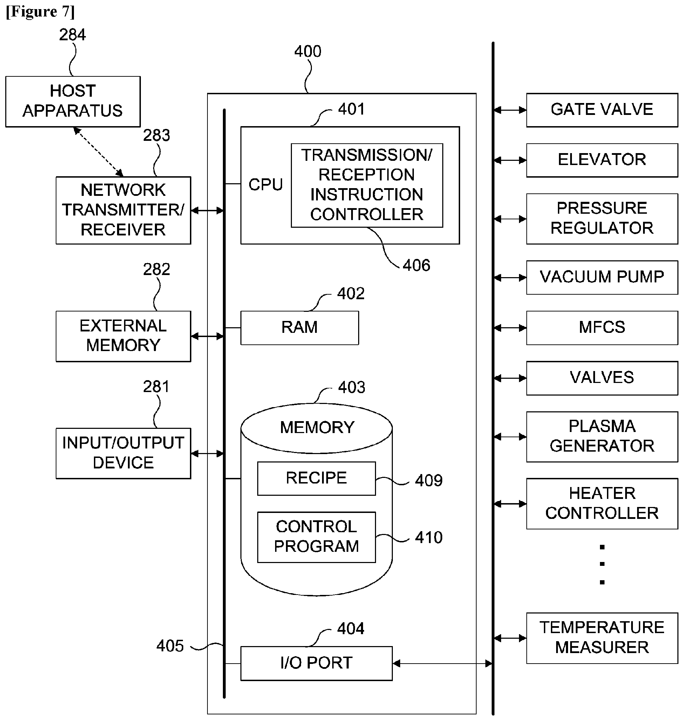

Subsequently, the controller 400 will be described with reference to FIG. 7. FIG. 7 is a block diagram schematically illustrating a functional configuration of the controller 400 of the substrate processing apparatus 100 according to the embodiments of the present disclosure.

The controller 400 serving as the control structure (control apparatus) may be embodied by a computer including a CPU (Central Processing Unit) 401, a RAM (Random Access Memory) 402, a memory 403 serving as a storage and an I/O port (input/output port) 404. The RAM 402, the memory 403 and the I/O port 404 may exchange data with the CPU 401 via an internal bus 405. Transmission/reception of data in the substrate processing apparatus 100 may be performed by an instruction from a transmission/reception instruction controller 406, which is also one of functions of the CPU 401.

The CPU 401 is configured to read and execute a control program from the memory 403 and read a process recipe from the memory 403 in accordance with an instruction such as an operation command inputted from an input/output device 281. Then, in accordance with contents of the read process recipe from the input/output device 281, the CPU 401 is configured to be capable of controlling various operations such as an opening and closing operation of the gate valve 149, an elevating and lowering operation of the elevator 218, a control operation of the heater controller 223, an ON/OFF control operation of each pump described above, a flow rate adjusting operation of each MFC described above and an opening/closing operation of each valve described above.

The memory 403 may be embodied by a component such as a flash memory and a HDD (hard disk drive). For example, a recipe 409 such as the process recipe in which information such as sequences and conditions of a substrate processing described later is stored and the control program 410 for controlling the operations of the substrate processing apparatus 100 is stored may be readably stored in the memory 403.

The process recipe is obtained by combining the sequences (steps) of the substrate processing described later such that the controller 400 can execute the steps to acquire a predetermined result, and functions as a program. Hereinafter, the process recipe and the control program may be collectively or individually referred to simply as a "program." Thus, in the present specification, the term "program" may refer to the process recipe alone, may refer to the control program alone, or may refer to both of the process recipe and the control program.

The RAM 402 serves as a memory area (work area) in which the program or the data read by the CPU 401 can be temporarily stored.

The I/O port 404 is electrically connected to the components of the substrate processing apparatus 100 described above such as the gate valve 149, the elevator 218, each pressure regulator described above, each pump described above and the heater controller 223.

Further, a network transmitter/receiver 283 capable of communicating with a host apparatus 284 via a network is connected to the controller 400. The network transmitter/receiver 283 is capable of receiving data such as information regarding a processing history and a processing schedule of the product substrate 200 in a lot.

For example, the controller 400 according to the present embodiments may be embodied by preparing an external memory 282 storing the program described above therein and by installing the program onto the computer by using the external memory 282. For example, the external memory 282 may include a magnetic disk such as a hard disk, an optical disk such as a DVD, a magneto-optical disk such as an MO or a semiconductor memory such as a USB memory. Further, a structure of providing the program to the computer is not limited to the external memory 282. For example, the program may be directly provided to the computer by a communication interface such as the Internet and a dedicated line instead of the external memory 282. Further, the memory 403 and the external memory 282 may be embodied by a non-transitory computer-readable recording medium. Hereinafter, the memory 403 and the external memory 282 may be collectively or individually referred to as a recording medium. Thus, in the present specification, the term "recording medium" may refer to the memory 403 alone, may refer to the external memory 282 alone, or may refer to both of the memory 403 and the external memory 282.

### (2) Substrate Processing

Subsequently, as a part of a method of manufacturing a semiconductor device, a step (that is, the substrate processing) of forming a film on the product substrate 200 using the substrate processing apparatus 100 with the configuration described above will be described. In the following description, the controller 400 controls the operations of the components constituting the substrate processing apparatus 100.

In the present specification, the term "substrate" may refer to "a substrate itself', or may refer to "a substrate and a stacked structure (aggregated structure) of a predetermined layer (or layers) or a film (or films) formed on a surface of the substrate" (that is, the term "substrate" may collectively refer to "a substrate and a layer (or layers) or a film (or films) formed on a surface of the substrate"). Further, in the present specification, the term "a surface of a substrate" may refer to "a surface (exposed surface) of a substrate itself', or may refer to "a surface of a predetermined layer or a film formed on a substrate, i.e. a top surface (uppermost surface) of the substrate as a stacked structure". Thus, in the present specification, "supplying a predetermined gas to a substrate" may refer to "directly supplying a predetermined gas to a surface (exposed surface) of a substrate itself', or may refer to "supplying a predetermined gas to a layer or a film formed on a substrate", that is, "supplying a predetermined gas to a top surface (uppermost surface) of a substrate as a stacked structure". In addition, in the present specification, "forming a predetermined layer (or film) on a substrate" may refer to "forming a predetermined layer (or film) directly on a surface (exposed surface) of a substrate itself" or may refer to "forming a predetermined layer (or film) on a layer (or film) formed on a substrate, i.e. a top surface (uppermost surface) of the substrate as a stacked structure". In the present specification, the terms "substrate" and "wafer" may be used as substantially the same meaning. In such a case, the term "substrate" may be replaced with the term "wafer".

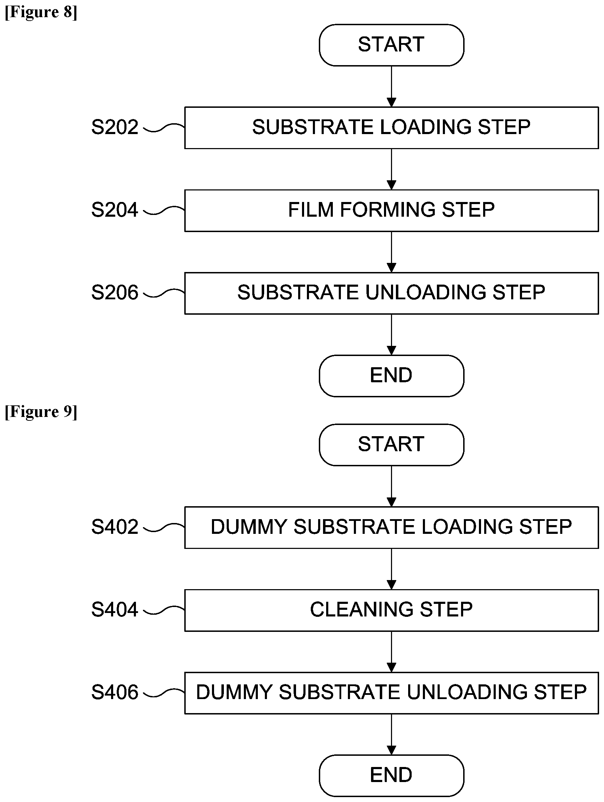

FIG. 8 is a flow diagram schematically illustrating the substrate processing according to the present embodiments. In the present embodiments, as the substrate processing, an example in which a silicon nitride (SiN) film is formed as a silicon-containing film on the product substrate 200 by an alternate supply method will be described. The substrate processing includes at least a substrate loading step (step S202, hereinafter, "step" will be abbreviated as "S"), a film forming step (S204) and a substrate unloading step (S206).

### <Substrate Loading Step: S202>

In the substrate loading step S202, the product substrate 200 stored in the pod 111 on the I/O stage 110 is transferred (loaded) into the chamber RC of the process module PM through the atmospheric transfer chamber 120, the load lock chamber 130 and the vacuum transfer chamber 140.

In the present step, in the process chamber 201 of the chamber RC, the substrate mounting table 212 is lowered to the substrate transfer position such that the lift pins 207 penetrate through the through-holes 214 of the substrate mounting table 212, respectively. As a result, the lift pins 207 protrude from a surface of the substrate mounting table 212 by a predetermined height. Subsequently, after regulating an inner pressure of the process chamber 201 to a predetermined pressure, the gate valve 149 is opened to communicate an inside of the process chamber 201 with the vacuum transfer chamber 140. Then, the product substrate 200 is placed on the lift pins 207 from the vacuum transfer chamber 140 via the gate valve 149. After placing the product substrate 200 on the lift pins 207, by elevating the substrate mounting table 212 to a predetermined position, the product substrate 200 is placed from the lift pins 207 onto the substrate placing surface 211 of the substrate mounting table 212. When placing the product substrate 200 on the substrate placing surface 211, by supplying the electric power to the heater 213, the heater 213 is controlled such that a temperature of the surface of the product substrate 200 is adjusted to a predetermined temperature.

### <Film Forming Step: S204>

In the film forming step S204, a process of forming the SiN film on the surface of the product substrate 200 placed on the substrate placing surface 211 is performed. The process performed in the present step is a cyclic process in which a step of alternately supplying different process gases is repeatedly performed.

Specifically, first, the inner pressure of the process chamber 201 is adjusted. When the inner pressure of the process chamber 201 reaches a desired pressure, by controlling the first gas supplier 241 and the second gas supplier 242 to alternately supply the first gas and the second gas into the process chamber 201, the product substrate 200 in the process chamber 201 is processed. For example, the process in the present step refers to a process of forming a predetermined film on the product substrate 200 by reacting the first gas with the second gas. According to the present embodiments, the SiN film is formed on the surface of the product substrate 200 by supplying the HCDS gas as the first gas and supplying the NH₃ gas as the second gas.

In the present step, for example, a supply of the first gas and a supply of the second gas are repeatedly performed a plurality number of times. A purge step (purge process) of supplying an inert gas such gas N₂ gas may be performed between the supply of the first gas and the supply of the second gas or between the supply of the second gas and the supply of the first gas. Further, during the supply of the second gas, the RPU 242e may be operated to convert the second gas into the plasma state. By performing the cyclic process described above, it is possible to form the SiN film with a predetermined thickness on the product substrate 200.

For example, process conditions of the present step are as follows:
The first gas: HCDS
A gas supply amount of the first gas: from 5 sccm to 5,000 sccm;
The second gas: NH₃
A gas supply amount of the second gas: from 10 sccm to 10,000 sccm;
The inner pressure of the process chamber: from 133 Pa to 13,332 Pa; and
A process temperature: from 300 °C to 500 °C.

### <Substrate Unloading Step: S206>

In the substrate unloading step S206, the product substrate 200 (which is processed) is transferred (unloaded) out of the process chamber 201 in the order reverse to that of loading the product substrate 200 in the substrate loading step S202. As a result, the product substrate 200 (which is processed) is stored in the pod 111 on the I/O stage 110.

As described above, when performing the substrate processing in the substrate processing apparatus 100 according to the present embodiments, the controller 400 is configured to be capable of controlling the components of the substrate processing apparatus 100 so as to process the product substrate 200 by supplying the process gas into the process chamber 201 in a state where the product substrate 200 is supported on the substrate placing surface 211.

### (3) Cleaning Process

After performing the substrate processing described above, at a predetermined timing (for example, after processing a predetermined number of the product substrates 200, or after a predetermined period of operating the substrate processing apparatus 100), it is preferable to perform the cleaning process of removing the substance such as the by-product attached to the inside of the process chamber 201.

Subsequently, a procedure of the cleaning process (that is, a cleaning method according to the present embodiments) performed by the substrate processing apparatus 100 with the configuration described above will be described. In the following description, the controller 400 controls the operations of the components constituting the substrate processing apparatus 100.

In the substrate processing apparatus 100 according to the present embodiments, the outer circumference of the substrate placing surface 211 is set to be greater than the outer shape of the product substrate 200, and the outer peripheral end of the product substrate 200 is supported by the second surface 211b of the substrate placing surface 211. Therefore, when the process gas is supplied into the process chamber 201 in the film forming step S204 of the substrate processing described above, the process gas may enter (or may be supplied) between the back surface of the product substrate 200 and the substrate placing surface 211 from the outer peripheral end side of the product substrate 200 on the substrate placing surface 211. Thus, the substance such as the by-product may be formed on the second surface 211b of the substrate placing surface 211 due to the process gas that has entered between the back surface of the product substrate 200 and the substrate placing surface 211. It is preferable to remove the substance such as the by-product formed on the second surface 211b by the cleaning process as a cleaning target (which is an object to be cleaned).

Further, in the substrate processing apparatus 100 according to the present embodiments, since the outer circumference of the substrate placing surface 211 is set to be greater than the outer shape of the product substrate 200, the film may be continuously formed on the surface of the product substrate 200 (the surface to be processed) and the substrate placing surface 211 outside the outer peripheral end thereof. Such a phenomenon may cause sticking, which makes it difficult for the product substrate 200 to separate from the substrate placing surface 211, and may also cause a foreign matter to be generated within the process chamber 201. Therefore, it is preferable to remove the cleaning target from an outer area of the outer peripheral end of the product substrate 200 by the cleaning process.

From the above, in the substrate processing apparatus 100 according to the present embodiments, in order to effectively perform the cleaning process especially on the second surface 211b of the substrate placing surface 211, the cleaning process is performed according to the procedure described below.

FIG. 9 is a flow diagram schematically illustrating the cleaning process according to the present embodiments. The cleaning process according to the present embodiments includes at least a dummy substrate loading step S402, a cleaning step S404 and a dummy substrate unloading step S406.

### <Dummy Substrate Loading Step: S402>

In the dummy substrate loading step S402, the dummy substrate 200D stored in the dummy substrate stocker 112 on the I/O stage 110 is transferred (loaded) into the chamber RC (to which the cleaning process is performed) of the process module PM through the atmospheric transfer chamber 120, the load lock chamber 130 and the vacuum transfer chamber 140.

In the present step, in the process chamber 201 of the chamber RC, the dummy substrate 200D is placed on the substrate placing surface 211 of the substrate mounting table 212 in substantially the same procedure as in the substrate loading step S202 described above.

The dummy substrate 200D is placed on the substrate placing surface 211 by using the pre-aligner 123 such that the position of the notch 200Da of the dummy substrate 200D is aligned with the position of the notch 200a in a case where the product substrate 200 is supported (that is, the dummy substrate 200D is placed in a manner that the notch 200Da is aligned in the predetermined direction). Further, the dummy substrate 200D is placed on the substrate placing surface 211, that is, on the third surface 211c of the substrate placing surface 211 such that the outer circumference of the dummy substrate 200D is concentric with the outer circumference of the product substrate 200. Thereby, after placing the dummy substrate 200D, the third surface 211c of the substrate placing surface 211 is covered with the dummy substrate 200D. As a result, the first surface 211a and second surface 211b (which are provided outside the third surface 211c) are exposed in the process chamber 201.

### <Cleaning Step: S404>

In the cleaning step S404, by supplying the cleaning gas into the process chamber 201, the cleaning process is performed on the substrate placing surface 211 on which the dummy substrate 200D is placed. Specifically, by controlling the third gas supplier 243 to supply the cleaning gas into the process chamber 201, the substance such as the by-product is removed by the cleaning gas.

In the present step, the third surface 211c of the substrate placing surface 211 is covered with the dummy substrate 200D. Therefore, even when the cleaning gas is supplied, the third surface 211c will not be damaged by the cleaning gas.

Further, the first surface 211a and the second surface 211b of the substrate placing surface 211 are exposed in the process chamber 201. Therefore, by supplying the cleaning gas into the process chamber 201, it is possible to reliably remove the substance such as the by-product attached to the first surface 211a and the second surface 211b. In other words, even when the substance such as the by-product is formed on the second surface 211b by the process gas that has entered between the back surface of the product substrate 200 and the substrate placing surface 211 in the film forming step S204, it is possible to effectively remove the substance such as the by-product on the second surface 211b. The same also applies to the first surface 211a.

Further, in a case where the cleaning gas resistant structure is provided on the second surface 211b, even when the second surface 211b is exposed in the process chamber 201 and the cleaning gas is directly supplied to the second surface 211b, it is possible to suppress the influence of the cleaning gas. In other words, it is possible to suppress a damage to the second surface 211b by the cleaning gas resistant structure. Thereby, it is possible to effectively perform the cleaning process on the second surface 211b. The same also applies to a case where the cleaning gas resistant structure is provided on the first surface 211a.

When a predetermined time has elapsed from a start of a supply of the cleaning gas, by controlling the third gas supplier 243 to stop the supply of the cleaning gas into the process chamber 201, the cleaning step S404 is terminated.

### <Dummy Substrate Unloading Step: S406>

After the cleaning step S404 is completed, in the dummy substrate unloading step S406, the dummy substrate 200D is transferred (unloaded) out of the process chamber 201 in the order reverse to that of loading the dummy substrate 200D in the dummy substrate loading step S402. As a result, the dummy substrate 200D is stored in the dummy substrate stocker 112 on the I/O stage 110.

As described above, in the substrate processing apparatus 100 according to the present embodiments, when performing the cleaning process, the cleaning gas is supplied to at least a portion (which corresponds to the outer circumference of the dummy substrate 200D) of the substrate placing surface 211 in a state where the dummy substrate 200D is supported on the substrate placing surface 211. Further, the controller 400 is configured to be capable of controlling the components of the substrate processing apparatus 100 so as to remove the cleaning target (which is formed due to the process gas that has entered between the back surface of the product substrate 200 and the substrate placing surface 211 when the product substrate 200 is processed) by performing the cleaning process.

In addition, in the substrate processing apparatus 100 according to the present embodiments, when performing the cleaning process, the dummy substrate 200D is transferred between the process chamber 201 in each of the chamber RC1 to RC8 and the dummy substrate stocker 112 on the I/O stage 110 via the vacuum transfer chamber 140. More specifically, the process chamber 201 in each of the chamber RC1 to RC8 is provided adjacent to the vacuum transfer chamber 140, the vacuum transfer chamber 140 is provided adjacent to the load lock chamber 130, and the load lock chamber 130 is provided adjacent to the atmospheric transfer chamber 120. The dummy substrate stocker 112 is arranged on the I/O stage 110 provided adjacent to the atmospheric transfer chamber 120. Then, the dummy substrate 200D is transferred between the process chamber 201 and the dummy substrate stocker 112 via the vacuum transfer chamber 140, the load lock chamber 130 and the atmospheric transfer chamber 120.

### (4) Method of Manufacturing Semiconductor Device

According to the present embodiments, by processing the product substrate 200 by performing the substrate processing including the cleaning process described above as a part of the method of manufacturing the semiconductor device, it is possible to manufacture the semiconductor device.

### (5) Effects according to Present Embodiments

According to the present embodiments, it is possible to obtain one or more of the following effects.
(a) According to the present embodiments, during the cleaning process in the process chamber 201, the cleaning gas is supplied to at least the portion (which corresponds to the outer circumference of the dummy substrate 200D) of the substrate placing surface 211 in a state where the dummy substrate 200D is supported on the substrate placing surface 211. Therefore, even when the cleaning target such as the by-product is formed due to the process gas that has entered between the back surface of the product substrate 200 and the substrate placing surface 211 when the product substrate 200 is processed, it is possible to remove the cleaning target. In other words, by using the dummy substrate 200D whose diameter is smaller than that of the product substrate 200, it is possible to effectively perform the cleaning process.
(b) According to the present embodiments, the dummy substrate 200D whose shape is substantially the same as that of the product substrate 200 is used. Thereby, when the dummy substrate 200D is placed on the substrate placing surface 211, the position of the notch 200Da or the orientation flat of the dummy substrate 200D is aligned with the position of the notch 200a of the orientation flat of the product substrate 200 in a case where the product substrate 200 is placed on the substrate placing surface 211, and the distance L between the outer circumference of the dummy substrate 200D and the outer circumference of the product substrate 200 is the constant distance. Therefore, it is particularly effective in removing the cleaning target (which is formed by the process gas that has entered between the back surface of the product substrate 200 and the substrate placing surface 211). This is because it is considered that the process gas enters into a uniform area from the outer peripheral end of the product substrate 200.
(c) According to the present embodiments, the dummy substrate 200D is loaded into or unloaded out of the process chamber 201 through the vacuum transfer chamber 140 and the like. Therefore, for example, in a case where the dummy substrate stocker 112 is arranged on the I/O stage 110, if the substrate processing apparatus 100 includes the vacuum transfer chamber 140 and the like (for example, even when the substrate processing apparatus 100 is an existing substrate processing apparatus), it is possible to perform the cleaning process using the dummy substrate 200D.
(d) According to the present embodiments, the substrate placing surface 211 includes the first surface 211a, the second surface 211b and the third surface 211c, and the cleaning gas resistant structure is provided on at least the second surface 211b. Therefore, even when the cleaning gas is directly supplied to the second surface 211b, it is possible to suppress the influence of the cleaning gas, and it is also possible to suppress the damage to the second surface 211b. The same also applies to the case where the cleaning gas resistant structure is provided on the first surface 211a.
(e) According to the present embodiments, when processing the product substrate 200 in the process chamber 201, the edge of the back surface of the product substrate 200 is supported by the second surface 211b of the substrate placing surface 211. In such a configuration, in addition to the by-product formed due to the process gas that has entered to a back side of the product substrate 200, there may be another problem in that sticking may occur near the outer peripheral end of the product substrate 200.
Such problem may be overcome by performing the cleaning process using the dummy substrate 200D as in the present embodiments.

### (6) Other Embodiments of Present Disclosure

While the technique of the present disclosure is described in detail by way of the embodiments described above, the technique of the present disclosure is not limited thereto. The technique of the present disclosure may be modified in various ways without departing from the scope thereof.

For example, the embodiments described above are described by way of an example in which, in a film forming process performed by the substrate processing apparatus 100, the SiN film is formed on the product substrate 200 by using the HCDS gas as the first gas and the NH₃ gas as the second gas and by alternately supplying the HCDS gas and the NH₃ gas. However, the technique of the present disclosure is not limited thereto. That is, the process gases used in the film forming process are not limited to the HCDS gas and the NH₃ gas, and other gases may be used to form different films. Further, the technique of the present disclosure may also be applied to other film forming processes using three or more process gases as long as the three or more process gases are non-simultaneously supplied.

For example, the embodiments described above are described by way of an example in which the film forming process is performed by the substrate processing apparatus 100. However, the technique of the present disclosure is not limited thereto. That is, in addition to or instead of the film forming process exemplified above, the technique of the present disclosure can be applied to another process such as a process of forming an oxide film, a process of forming a nitride film and a process of forming a film containing a metal element. Further, specific contents of the substrate processing are not limited. For example, in addition to or instead of the film forming process exemplified above, the technique of the present disclosure can be preferably applied to another substrate processing such as an annealing process, an oxidation process, a nitridation process, a diffusion process and a lithography process. Further, for example, the technique of the present disclosure may also be applied to other substrate processing apparatuses such as an annealing apparatus, an oxidation apparatus, a nitridation apparatus, an exposure apparatus, a coating apparatus, a drying apparatus, a heating apparatus, an apparatus using the plasma and combinations thereof. The technique of the present disclosure may also be applied when a constituent of an embodiment of the technique of the present disclosure is substituted with another constituent of another embodiment of the technique of the present disclosure, or when a constituent of the embodiment is added to another embodiment. Further, the technique of the present disclosure may also be applied when the constituent of the embodiment is omitted or substituted, or when a constituent is added to the embodiment.

Further, in the present specification, a notation of a numerical range such as "from 5 sccm to 5,000 sccm" means that a lower limit and an upper limit are included in the numerical range. Therefore, for example, the numerical range "from 5 sccm to 5,000 sccm" means a range equal to or higher than 5 sccm and equal to or lower than 5,000 sccm. The same also applies to other numerical ranges described herein.

The present invention may be summarized as follows: There is provided a technique capable of effectively performing a cleaning process. There is provided a technique that includes: a process chamber; a process gas supplier; a cleaning gas supplier; a substrate support including a substrate placing surface for supporting a product substrate or a dummy substrate whose diameter is smaller than that of the product substrate; and a controller capable of control operations for processing the product substrate by supplying the process gas; and performing a cleaning process on a cleaning target formed by the process gas entering between a back surface of the product substrate and the substrate placing surface, wherein the cleaning process is performed by supplying the cleaning gas to at least a portion of the substrate placing surface corresponding to an outer circumference of the dummy substrate in a state where the dummy substrate is supported on the substrate placing surface.

### [Description of Reference Numerals]

| | | | |
|---|---|---|---|
| 100: | substrate processing apparatus | 110: | I/O stage |
| 120: | atmospheric transfer chamber | 130: | load lock chamber |
| 140: | vacuum transfer chamber | 200: | product substrate |
| 200D: | dummy substrate | 201: | process chamber |
| 210: | substrate support | 211: | substrate placing surface |
| 241: | first gas supplier | 242: | second gas supplier |
| 243: | third gas supplier | 400: | controller |
| PM: | process module | RC: | chamber |

## Claims

1. A substrate processing apparatus comprising:
(a) a process chamber;
(b) a process gas supplier configured to supply a process gas into the process chamber;
(c) a cleaning gas supplier configured to supply a cleaning gas into the process chamber;
(d) a substrate support provided with a substrate placing surface on which a product substrate or a dummy substrate whose diameter is smaller than that of the product substrate is capable of being supported; and
(e) a controller configured to be capable of controlling the process gas supplier and the cleaning gas supplier to perform:
processing the product substrate by supplying the process gas in a state where the product substrate is supported on the substrate placing surface; and
performing a cleaning process on a cleaning target formed by the process gas that has entered between a back surface of the product substrate and the substrate placing surface when the product substrate is processed,
wherein the cleaning process is performed by supplying the cleaning gas to at least a portion of the substrate placing surface corresponding to an outer circumference of the dummy substrate in a state where the dummy substrate is supported on the substrate placing surface.

2. The substrate processing apparatus of claim 1, wherein a shape of the dummy substrate is substantially the same as that of the product substrate.

3. The substrate processing apparatus of claim 1 and/or 2, wherein a notch or an orientation flat is formed on each of the product substrate and the dummy substrate, and
when supporting the dummy substrate on the substrate placing surface, the dummy substrate is placed in a manner that a position of the notch or the orientation flat of the dummy substrate is aligned with a position of the notch or the orientation flat of the product substrate in a case where the product substrate is supported on the substrate placing surface.

4. The substrate processing apparatus of any one or more of claims 1 to 3, wherein the outer circumference of the dummy substrate is set such that a distance between the outer circumference of the dummy substrate and an outer circumference of the product substrate is a constant distance.

5. The substrate processing apparatus of any one or more of claims 1 to 4, further comprising:
one or more process chambers;
a vacuum transfer chamber provided adjacent to the process chamber and the one or more process chambers; and
a dummy substrate storage where the dummy substrate is stored,
wherein the dummy substrate is transferred between the dummy substrate storage and the process chamber or the one or more process chambers via the vacuum transfer chamber.

6. The substrate processing apparatus of any one or more of claims 1 to 5, further comprising:
one or more process chambers;
a vacuum transfer chamber provided adjacent to the process chamber and the one or more process chambers;
a load lock chamber provided adjacent to the vacuum transfer chamber;
an atmospheric transfer chamber provided adjacent to the load lock chamber; and
a dummy substrate storage provided adjacent to the atmospheric transfer chamber.

7. The substrate processing apparatus of any one or more of claims 1 to 6, wherein the substrate placing surface comprises:
a first surface whose outer edge is defined by an outer circumference of the substrate placing surface;
a second surface located inside the first surface and configured to be capable of supporting an outer peripheral end of the product substrate; and
a third surface located inside the second surface and whose outer edge is defined by the outer circumference of the dummy substrate,
wherein the first surface is provided with a cleaning gas resistant structure capable of suppressing an influence of the cleaning gas.

8. The substrate processing apparatus of any one or more of claims 1 to 7, wherein the substrate placing surface comprises:
a first surface whose outer edge is defined by an outer circumference of the substrate placing surface;
a second surface located inside the first surface and configured to be capable of supporting an outer peripheral end of the product substrate; and
a third surface located inside the second surface and whose outer edge is defined by the outer circumference of the dummy substrate,
wherein the second surface is provided with a cleaning gas resistant structure capable of suppressing an influence of the cleaning gas.

9. The substrate processing apparatus of claim 7 and/or 8, wherein the second surface is configured to be capable of supporting an edge of the back surface of the product substrate.

10. The substrate processing apparatus of any one or more of claims 7 to 9, wherein the influence of the cleaning gas is caused by an etching by the cleaning gas, and
the cleaning gas resistant structure is capable of suppressing the etching caused by the cleaning gas.

11. The substrate processing apparatus of any one or more of claims 7 to 10, wherein the cleaning gas resistant structure is of a ring structure in an annular shape.

12. A cleaning method comprising:
performing a cleaning process on a cleaning target by supplying a cleaning gas to at least a portion of a substrate placing surface corresponding to an outer circumference of a dummy substrate in a state where the dummy substrate whose diameter is smaller than that of a product substrate is supported on the substrate placing surface,
wherein the cleaning target is formed by a process gas that has entered between a back surface of the product substrate and the substrate placing surface when the product substrate is processed by supplying the process gas into a process chamber in a state where the product substrate is supported on the substrate placing surface of a substrate support provided in the process chamber.

13. A substrate processing method comprising:
(a) processing a product substrate by supplying a process gas into a process chamber in a state where the product substrate is supported on a substrate placing surface of a substrate support provided in the process chamber; and
(b) performing a cleaning process on a cleaning target formed by the process gas that has entered between a back surface of the product substrate and the substrate placing surface when the product substrate is processed,
wherein the cleaning process is performed by supplying a cleaning gas to at least a portion of the substrate placing surface corresponding to an outer circumference of a dummy substrate in a state where the dummy substrate whose diameter is smaller than that of the product substrate is supported on the substrate placing surface.

14. A method of manufacturing a semiconductor device, comprising the method of claim 12 and/or 13.

15. A program that causes a substrate processing apparatus, by a computer, to perform:
(a) processing a product substrate by supplying a process gas into a process chamber in a state where the product substrate is supported on a substrate placing surface of a substrate support provided in the process chamber; and
(b) performing a cleaning process on a cleaning target formed by the process gas that has entered between a back surface of the product substrate and the substrate placing surface when the product substrate is processed,
wherein the cleaning process is performed by supplying a cleaning gas to at least a portion of the substrate placing surface corresponding to an outer circumference of a dummy substrate in a state where the dummy substrate whose diameter is smaller than that of the product substrate is supported on the substrate placing surface.
